(19) **Europäisches Patentamt / European Patent Office / Office européen des brevets**

(11) **EP 4 253 975 B1**

(12) **EUROPEAN PATENT SPECIFICATION**

(45) Date of publication and mention
of the grant of the patent:
**11.02.2026 Bulletin 2026/07**

(21) Application number: **22165579.8**

(22) Date of filing: **30.03.2022**

(51) International Patent Classification (IPC):
**G01R 31/387** (2019.01)

(52) Cooperative Patent Classification (CPC):
**G01R 31/387**

(54) **BATTERY CAPACITY ESTIMATION USING RECURSIVE FILTER**

SCHÄTZUNG DER BATTERIEKAPAZITÄT UNTER VERWENDUNG EINES REKURSIVEN FILTERS

ESTIMATION DE LA CAPACITÉ D'UNE BATTERIE À L'AIDE D'UN FILTRE RÉCURSIF

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(43) Date of publication of application:
**04.10.2023 Bulletin 2023/40**

(73) Proprietor: **TWAICE Technologies GmbH
80807 München (DE)**

(72) Inventor: **FAIZI, Saifullah Inamullah
80993 München (DE)**

(74) Representative: **Kraus & Lederer PartGmbB
Thomas-Wimmer-Ring 15
80539 München (DE)**

(56) References cited:
**US-A1- 2015 349 385**

• PLETT ET AL: "Recursive approximate weighted
total least squares estimation of battery cell total
capacity", JOURNAL OF POWER SOURCES,
ELSEVIER, AMSTERDAM, NL, vol. 196, no. 4, 15
February 2011 (2011-02-15), pages 2319 - 2331,
XP027531171, ISSN: 0378-7753, [retrieved on
20100929]

**Description**

TECHNICAL FIELD

Various examples of the disclosure generally pertain to determining a capacity of a battery.

BACKGROUND

Rechargeable batteries such as lithium-ion batteries age. Their state-of-health (SOH) degrades. Specifically, the capacity - i.e., maximum extractable charge - degrades. Capacity is usually measured in ampere hours or milliampere hours.
The state-of-charge (SOC) is a value between 0% and 100% that indicates the relative level of charge presently held by the battery. A SOC of 100% corresponds to a "full" battery, while a SOC of 0% corresponds to an "empty" battery.
By measuring a SOC difference between two operating points of the battery and implementing Coulomb-counting, i.e., integrating the current flow over time, it is possible to determine the capacity. See, e.g., Eq. 2 of Plett, Gregory L. "Recursive approximate weighted total least squares estimation of battery cell total capacity." Journal of Power Sources 196.4 (2011): 2319-2331.

SUMMARY

A need exists for techniques of determining an estimate of a capacity of a battery. A need exists for techniques that enable determining the estimate of the capacity non-invasively (e.g., during normal use of the battery in a field application) and accurately. A need exists for techniques that are widely applicable to various types of batteries.
This need is met by the features of the independent claims. The features of the dependent claims define embodiments.
A computer-implemented method of estimating a capacity of a rechargeable battery is disclosed. The method includes obtaining, for a sequence of charging or discharging half-cycles of the rechargeable battery, respective pairs of state-of-charge difference values and charge throughput values. The method also includes determining a current estimate of the capacity for each charging or discharging half-cycle of the sequence of charging or discharging half-cycles. The current estimate of the capacity is determined by updating a previous estimate of the capacity of the rechargeable battery using a recursive filter. The recursive filter is based on a cost function. The cost function depends on a difference between the respective state-of-charge difference value and a reference state-of-charge difference value. The reference state-of-charge difference value is dependent on the respective charge throughput and the current estimate of the capacity.
A computer program or a computer-program product or a computer-readable storage medium includes program code. The program code can be loaded and executed by at least one processor. Upon executing the program code, the at least one processor performs a method of estimating a capacity of a rechargeable battery. The method includes obtaining, for a sequence of charging or discharging half-cycles of the rechargeable battery, respective pairs of state-of-charge difference values and charge throughput values. The method also includes determining a current estimate of the capacity for each charging or discharging half-cycle of the sequence of charging or discharging half-cycles. The current estimate of the capacity is determined by updating a previous estimate of the capacity of the rechargeable battery using a recursive filter. The recursive filter is based on a cost function. The cost function depends on a difference between the respective state-of-charge difference value and a reference state-of-charge difference value. The reference state-of-charge difference value is dependent on the respective charge throughput and the current estimate of the capacity.
A computing device comprises at least one processor and a memory. The processor is configured to load program code from the memory and execute the program code. Upon executing the program code the processor performs a method of estimating a capacity of a rechargeable battery. The method includes obtaining, for a sequence of charging or discharging half-cycles of the rechargeable battery, respective pairs of state-of-charge difference values and charge throughput values. The method also includes determining a current estimate of the capacity for each charging or discharging half-cycle of the sequence of charging or discharging half-cycles. The current estimate of the capacity is determined by updating a previous estimate of the capacity of the rechargeable battery using a recursive filter. The recursive filter is based on a cost function. The cost function depends on a difference between the respective state-of-charge difference value and a reference state-of-charge difference value. The reference state-of-charge difference value is dependent on the respective charge throughput and the current estimate of the capacity.
It is to be understood that the features mentioned above and those yet to be explained below may be used not only in the respective combinations indicated, but also in other combinations or in isolation without departing from the scope of the invention as defined by the appended claims.

BRIEF DESCRIPTION OF THE DRAWINGS

FIG. 1 schematically illustrates a system according to various examples
FIG. 2 is a flowchart of a method according to various examples.
FIG. 3 schematically illustrates multiple estimates of the capacity of the battery over time according to reference implementations.
FIG. 4 schematically illustrates multiple estimates of the capacity of the battery over time according to reference implementations.

DETAILED DESCRIPTION

Some examples of the present disclosure generally provide for a plurality of circuits or other electrical devices. All references to the circuits and other electrical devices and the functionality provided by each are not intended to be limited to encompassing only what is illustrated and described herein. While particular labels may be assigned to the various circuits or other electrical devices disclosed, such labels are not intended to limit the scope of operation for the circuits and the other electrical devices. Such circuits and other electrical devices may be combined with each other and/or separated in any manner based on the particular type of electrical implementation that is desired. It is recognized that any circuit or other electrical device disclosed herein may include any number of microcontrollers, a graphics processor unit (GPU), integrated circuits, memory devices (e.g., FLASH, random access memory (RAM), read only memory (ROM), electrically programmable read only memory (EPROM), electrically erasable programmable read only memory (EEPROM), or other suitable variants thereof), and software which co-act with one another to perform operation(s) disclosed herein. In addition, any one or more of the electrical devices may be configured to execute a program code that is embodied in a non-transitory computer readable medium programmed to perform any number of the functions as disclosed.

In the following, embodiments of the invention will be described in detail with reference to the accompanying drawings. It is to be understood that the following description of embodiments is not to be taken in a limiting sense. The scope of the invention is not intended to be limited by the embodiments described hereinafter or by the drawings, which are taken to be illustrative only.

The drawings are to be regarded as being schematic representations and elements illustrated in the drawings are not necessarily shown to scale. Rather, the various elements are represented such that their function and general purpose become apparent to a person skilled in the art. Any connection or coupling between functional blocks, devices, components, or other physical or functional units shown in the drawings or described herein may also be implemented by an indirect connection or coupling. A coupling between components may also be established over a wireless connection. Functional blocks may be implemented in hardware, firmware, software, or a combination thereof.

Various examples of the disclosure pertain to determining an estimate of the capacity of a rechargeable battery, specifically lithium-ion batteries. These batteries may, e.g., be used in stationary energy storage systems or as traction batteries for electric vehicles.

The capacity is determined based on partitioning operation of the battery into half-cycles, i.e., periods during which the battery is continuously charged or discharged, respectively.

For each half-cycle, it is then possible to determine a SOC difference value, i.e., SOC value at beginning and end of the respective half-cycle respectively. Voltage-based SOC values can be used to do this, e.g., a model-based estimation of SOC values using voltage as input value. A machine-learning (ML) model - e.g., a neural network algorithm, e.g., a recurrent neural network algorithm - could be used. Such ML model can receive, as its input, a time sequence of the battery's terminal voltage (and optionally current flow). The ML model can be trained to predict the SOC values for a specific battery type or even for multiple battery types. This can be based on ground-truth data obtained from laboratory measurements of the SOC. It has been found that using such ML model provides a sufficient accuracy for predicting the SOC values, even when applied across different battery types ("transfer learning"). Here, training may be based on training data for a first type of batteries and inference can be based on data for a second type of batteries. This is specifically true where the SOC difference value thus obtained is treated as input signal to a filter, to thereby compensate for any residual errors, as will be explained below. This enables to provide for a scalable and, to a comparatively large extent, battery-type-agnostic means for estimating capacity.

For each half-cycle, it is also possible to perform Coulomb-counting, i.e., integrate the respective current flow in the battery over time. This yields a charge throughput value for each half-cycle.

Since such measurements are taken during operation, (i.e., for field-deployed batteries) they are subject to noise.

The relationship between SOC difference value and charge throughput value provides the capacity. However, due to the measurement noise, various techniques employ a recursive filter operating based on (time) sequences of respective SOC difference values and charge throughput values. As new data for a certain half-cycle comes in, the recursive filter determines a current estimate of the capacity by updating a previous estimate of the capacity.

It has been found that particular accurate estimates of the capacity can be determined by partitioning operation of the battery into half-cycles. Thereby, in particular, accurate estimates of the charge throughput values can be obtained, e.g., because sudden changes in the current are less likely to occur. In particular if compared to reference scenarios which employ, e.g., arbitrary sliding windows a more accurate estimate of the capacity can be determined.

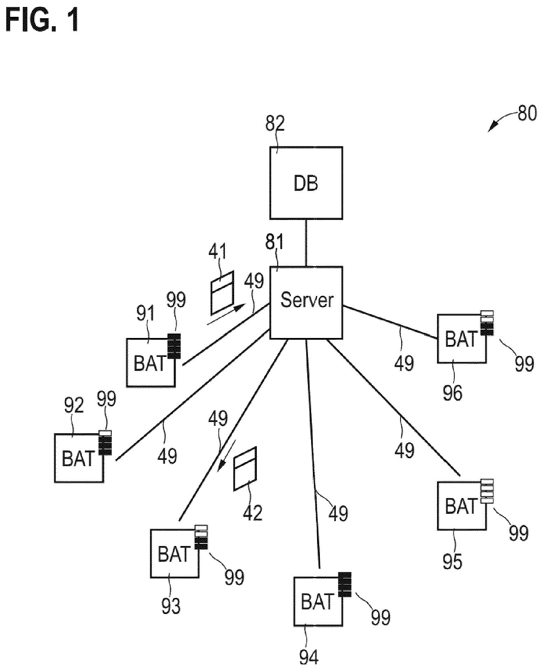

FIG. 1 illustrates aspects associated with a system 80. The system 80 comprises a server 81 which is connected to a database 82. In addition, the system 80 comprises communication connections 49 between the server 81 and each of several batteries 91-96. The communication connections 49 could be implemented, for example, via a cellular network.

In general, different battery types can be used in the various examples described herein. This means that the batteries 91-96 may comprise several types. Different types of batteries can be differentiated, for example, as relates to one or more of the following properties: shape of the cell (i.e., round cell, prismatic cell, etc.), cooling system (air cooling with active or passive design, coolant in coolant hose, passive cooling elements, etc.), the cell chemistry (e.g., electrode materials used, electrolytes, etc.), etc.

FIG. 1 illustrates by way of example that the batteries 91-96 can transmit state data 41 to the server 81 via the communication connections 49. For example, it would be possible for the state data 41 to be indicative of one or more operating values of the respective battery 91-96, i.e., it is possible to index measured data. The state data 41 can be transmitted in an event-driven manner or according to a predefined timetable.

For instance, time-resolved measurements of terminal voltage and current flow in the batteries can be provided to the server 81 by means of the state data 41, e.g., pack-etized for half-cycles. Based on this, the server 18 could determine SOC difference values and charge throughput values for the half-cycles, respectively. For this, the server 81 may access a database 82 where, e.g., respective models for estimating the SOC for different battery types based on terminal voltage are stored. It would also be possible that the SOC difference values and charge throughput values are determined at the batteries 91-96 and are provided to the server 81. For instance, each time a charging or discharging half-cycle is concluded, respective state date 41 could be provided to the server 81, the state data 41 including a respective SOC difference value and a respective charge throughput value, i.e., a pair of data values for this half-cycle.

The server 81 can be configured to determine a current estimate of the capacities 99 of each battery 91-96 based on the state data 41.

FIG. 1 also illustrates by way of example that the server 81 can transmit control data 42 to the batteries 91-96 via the communication connections 49. For example, it would be possible for the control data 42 to index one or more operating limits for the future operation of the respective battery 91-96. For example, the control data could index one or more control parameters for thermal management of the respective battery 91-96 and/or charge management of the respective battery 91-96. The server 81 can thus influence or control the operation of the batteries 91-96 through the use of the control data 42. For instance, the server 81 may determine the control data based on the current estimate of the capacity 99. Thereby, for aged batteries, stress factors can be reduced thereby prolonging battery life.

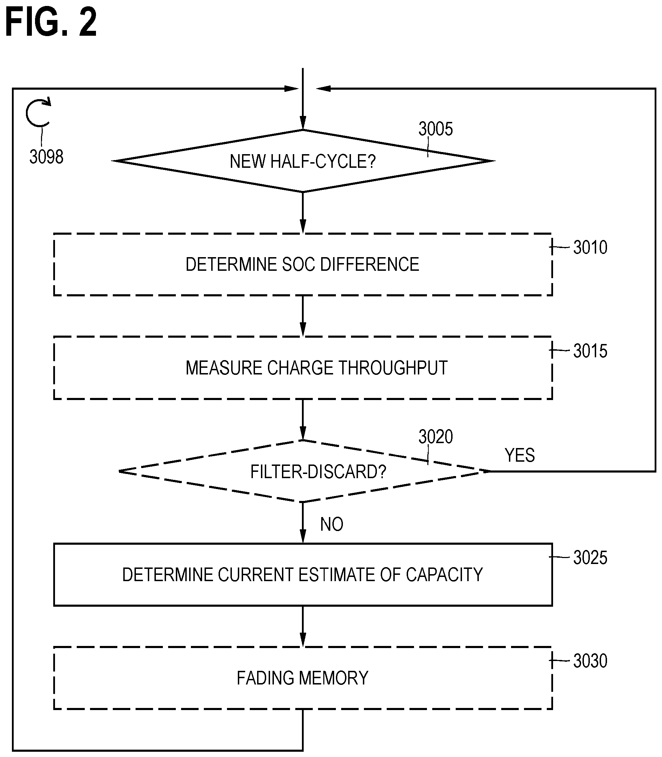

Next, techniques for determining the current estimate of the capacity 99 are described in connection with FIG. 2.

FIG. 2 is a flowchart of a method according to various examples. Optional boxes are shown with dashed lines. FIG. 2 is a method that facilitates determining an estimate of the capacity of a rechargeable battery. Specifically, changes of the capacity over the lifetime can be tracked.

The method of FIG. 2 may be executed by the server 81, e.g., by at least one processor of the server 81 upon loading and executing program code from a memory.

At box 3005, it is determined whether a new half-cycle of charging or discharging is started. This can involve detecting a rest phase (no charging or discharging current) and a subsequent charging or discharging current.

At box 3010, a depth of discharge (DOD) is determined for the current half-cycle. I.e., a SOC difference value is determined. $\Delta SOC_i$. The SOCs at the beginning and end of the half-cycle can be determined, e.g., using a voltage-SOC curve and/or using models, e.g., ML models.

Specifically, the end of the charging or discharging half-cycle can be detected by monitoring the charging or discharging current in the battery. Where the charging or discharging current, for a predetermined duration, falls below a predetermined threshold, completion of a half-cycle of charging or discharging can be assumed.

At box 3015, the charge throughput value $\Delta Q$ in the current half-cycle is measured. This includes Coulomb-counting, i.e., integrating over time the current flow. A trapezoidal sum of the current flow throughout the charging or discharging half-cycles may be calculated, which is computationally efficient and further reduces errors of the charge-throughput value.

$$\Delta Q_i = \int_{\text{Half-cycle } i} I dt \approx \sum_{\text{Half-cycle } i} I \cdot \delta t$$

$$(1)$$

$i$ is the index of the iterations 3098.

Eq. 1 does not depend on the type of the battery and can, accordingly, be employed for various types of batteries.

Accordingly, at boxes 3005, 3010, and 3015, the SOC difference value and the charge throughput value are obtained for a respective half-cycle. Respective value pairs are obtained for each sequence entry of the sequence of half-cycles. While in the illustrated examples these values are extracted from a time series of voltage and current data, in some scenarios such time series may be pre-processed, e.g., at a battery management system of a battery, and the SOC difference value and the charge throughput value may be obtained as pre-prepared data for each half-cycle (cf. FIG. 1: state data 41). A server may obtain these value pairs from, e.g., a battery management system of the battery.

At box 3020, it is then possible to apply one or more pre-filters to the data acquired at boxes 3010 and 3015. These filters do not operate recursively.

For instance, it may be checked whether any given charge throughput value corresponds to an outlier. For instance, outliers may be defined with respect to the sequence of measured charge throughput values for subsequent half-cycles. Where the charge throughput value exceeds all previously observed charge throughput values or a predetermined threshold, then the respective SOC difference value and the respective charge throughput value may be discarded; the method then commences at box 3005. Outliers could also be defined with respect to a predetermined fixed threshold.

Alternatively or additionally it would be possible to discard the respective SOC difference value and charge throughput value if the SOC difference value is below a predetermined threshold, e.g., 20%. This is based on the finding that small SOC difference values can be associated with a significant relative error of the voltage-based SOC estimation.

At box 3025, a current estimate of the capacity is determined. This is based on the SOC difference value of box 3010 in the current iteration 3098, as well as based on the charge throughput value of box 3015 of the current iteration 3098. I.e., pairs of SOC difference values and charge throughput values of a sequence of half-cycles are used.

Specifically, a previous estimate of the capacity of the battery is used to determine the current estimate of the capacity. I.e., a recursive filter can be used. Using a recursive filter enables on-line estimation of the capacity as new value pairs come in.

Starting from the previous estimate of the capacity, the previous estimate of the capacity can be updated to yield the current estimate of the capacity.

For instance, it would be possible to use the recursive filter considering a cost function that is minimized or maximized (depending on its formulation) by the recursive filter, since it describes an error of the measurement. The cost function is based on a difference between the measured charge throughput value of box 3015 of the current iteration 3098 and a reference charge throughput value. One of these values is assumed to be an input signal of the recursive filter (i.e., assumed to subject to significant measurement error); while the other one of these values of the value pair is assumed to relate to an output signal of the filter (i.e., assumed to be subject to a comparatively smaller error).

This reference charge throughput value can be obtained from the SOC difference value of box 3010 and the current estimate of the capacity $C_i$ according to:

$$\Delta Q_{\text{ref}} = \Delta SOC_i \cdot C_i$$

$$(2)$$

Hence, the cost function can be given by

$$\arg C_i \min\left(\sum_i (\Delta Q_i - \Delta SOC_i \cdot C_i)^2\right)$$

$$(3)$$

According to Eq. 3 it is, in other words, assumed that the $\Delta SOC_i$ corresponds to an input signal of the recursive filter and the accumulated current $\Delta Q_i$ (i.e., charge throughput value) corresponds to an output signal to the recursive filter (sometimes referred to as innovation process). This is motivated by the fact that, typically, the SOC difference value will have a larger error if compared to the charge throughput value.

As a general rule, various options are available to minimize such a cost function recursively.

For instance, a recursive least square (RLS) filter can be used to minimize the cost function according to Eq. 3. An alternative to the RLS filter would be a Kalman filter using a cost function defined by Eq. 3 or a similar cost function considering such difference.

In the RLS filter, the unknown coefficients of the filter are calculated in such a way that aims to minimize the sum of the squares of the differences between the observed signal and the output signal of the algorithm for each half-cycle of the sequence of half-cycles. The recursive nature of the filter allows to use the previous estimate of the capacity to avoid having to calculate the least squares solution across all tracked half-cycles. The respective implementation of an RLS filter is generally known to the skilled person, e.g., from Karavalakis, Nikolaos. "Online capacity estimation of Li-ion batteries with Errors-In-Variables model." (2019): Eqs. 3.9-3.12.

Briefly, the covariance and the previous estimate of the capacity are memorized and combined with the new capacity estimate ($C_i$) for each half-cycle.

A specific implementation of the RLS filter relies on a fading memory parameter. This fading memory parameter $\alpha$ is considered in the cost function to put emphasis on the recent value pairs:

$$\arg C_i \min\left(\sum_i \alpha^{i-1}(\Delta Q_i - \Delta SOC_i \cdot C_i)^2\right)$$

$$(4)$$

Here, $\alpha < 1$. Typically, $\alpha = 0.97$. Thereby, in Eq. 4, deviations between input and output signal of the RLS filter are amplified for larger $i$ (due to $i$ being used in the exponent), i.e., for more current value pairs. I.e., differences between SOC difference values and charge throughput values for more recent value pairs are overemphasized (in relation to older value pairs).

When using the above-formulated cost function, the RLS filter equations as outlined below are obtained, where k is the RLS working index across iterations 3098 (cf. FIG. 2; corresponding to $i$).

$$g[k + 1] = P[k] * \Delta SOC[k + 1]/(\alpha + (P[k] * \Delta SOC[k + 1]^2)) \qquad (5)$$

$$e[k + 1] = (\Delta Q[k + 1] - \Delta SOC[k + 1] * C[k]) \qquad (6)$$

$$C[k + 1] = C[k] + g[k + 1] * e[k + 1] \qquad (7)$$

$$P[k + 1] = ((P[k] - (g[k + 1] * \Delta SOC[k + 1] * P[k])) / \alpha) \qquad (8)$$

where :g=gain, e=error, P=covariance, $\alpha$=fading memory,
$\Delta Q$= charge throughput value , $C$=Capacity Estimate $\Delta SOC$ SOC difference value

As can be seen, in Eq. 7 the previous capacity estimate is updated by the gain multiplied by the gain multiplied with the error (Eqs. 5 and 6) to yield the new estimate of the capacity. The gain depends on the current SOC difference value, yet normalized based on the fading memory factor. Eq. 8 updates the covariance.

Using an implementation of the fading memory using the fading memory parameter in the cost function as discussed in connection with Eq. 4 is only one option. In this option, box 3025 and box 3030 (cf. FIG. 2) are jointly implemented by the RLS filter calculation. In another example, it would be possible to, e.g., consider the fading memory in a post-processing of the RLS filter output, e.g., by retaining C[k+1], C[k], C[k-1],... and then adjusting C[k+1] based on a weighted average that gives higher average to k+1 than to k or k-1. Here, it is possible that the innovation of box 3025 (i.e., $C_i$) is additionally averaged (weighted combination) with one or more previous estimates of the capacity (i.e., $C_{i-1}$, $C_{i-2}$, ... $C_{i-m}$) where $m=0, 1, 2,$ etc. depending on the scenario. Since the most up-to-date one or more previous estimates are considered, this can be referred to as "fading memory"; outdated estimates of the capacity are discarded and need to be retained in the memory. Here, fixed weighting factors may be used.

$$C_i \leftarrow x_1 C_i + x_2 \overline{C_p}$$

$$(9)$$

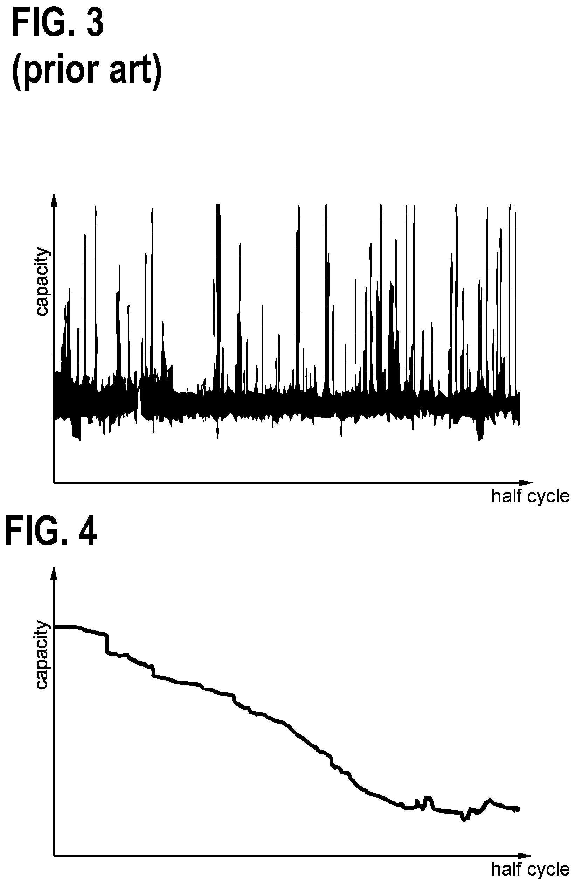

where $x_1$ is the weighting factor for the innovation associated with the current estimate of the capacity and $x_2$ is the weighting factor associated with the average of the one or more previous estimates of the capacities. For example, $x_1 = 0.03$ and $x_2 = 0.97$ has been tested to provide good results (cf. FIG. 4 below).

Then, once the current estimate of the battery has been determined for the current half-cycle, a further iteration 3098 - i.e., a new half-cycle - may be processed, and box 3005 is re-executed. Along with this the current estimate of the capacity and the associated current covariance are stored as previous estimate of capacity and previous estimate of covariance, to enable the recursive filter to update this previous estimate of the capacity to yield a new current estimate of the capacity.

FIG. 3 schematically illustrates the capacity calculated for each half-cycle of the sequence of half-cycles individually using

$$C_i^* = \frac{\Delta Q_i}{\Delta SOC_i}$$

$$(10)$$

As can be seen, there are sudden jumps resulting from the inaccuracies in the Coulomb-counting and, in particular, the determination of the SOC difference value. FIG. 4 illustrates the capacity calculated using the RLS filter with fading memory as described above in connection with FIG. 2.

Summarizing, techniques have been disclosed that facilitate determining an up-to-date estimate of the capacity using recursive filtering operating based on pairs of SOC difference values and charge throughput values obtained for a sequence of half-cycles.

Using a sequence of half-cycles has certain advantages over using moving time windows as, e.g., disclosed by Karavalakis, Nikolaos. "Online capacity estimation of Li-ion batteries with Errors-In-Variables model." (2019). These advantages are a more accurate measurement of the charge throughput values so that they can be treated as output signal of the RLS filter. Thereby, the overall accuracy can be increased, because a comparatively inaccurate voltage-based SOC difference value can be corrected. This enables the used of ML algorithms for the voltage-based SOC difference value, which provides for a fast and scalable way to make predictions for various types of batteries. Thus, somewhat battery-type-agnostic estimation of capacity becomes feasible.

Although the invention has been shown and described with respect to certain preferred embodiments, modifications will occur to others skilled in the art upon the reading and understanding of the specification. The present invention includes all such modifications and is limited only by the scope of the appended claims.

**Claims**

1. A computer-implemented method of estimating a capacity of a rechargeable battery, the method comprising:

    - obtaining (3010, 3015), for a sequence of charging or discharging half-cycles of the rechargeable battery, respective pairs of state-of-charge difference values and charge throughput values, and
    - for each charging or discharging half-cycle of the sequence of charging or discharging half-cycles, determining (3025) a current estimate of the capacity by updating a previous estimate of the capacity of the rechargeable battery based on a recursive filter,

    wherein the recursive filter is based on a cost function that depends on a difference between the respective state-of-charge difference value and a reference state-of-charge difference value, the reference state-of-charge difference value being dependent on the respective charge throughput and the current estimate of the capacity.

2. The computer-implemented method of claim 1,
    wherein the cost function overemphasizes differences between the state-of-charge difference values and reference state-of-charge difference values for more recent charging or discharging half-cycles.

3. The computer-implemented method of claim 1 or 2, further comprising:

- discarding (3020) one or more pairs of state-of-charge difference values and charge throughput values if the respective state-of-charge difference values are below a predetermined threshold.

4. The computer-implemented method of any one of the preceding claims, further comprising:

- discarding (3020) one or more pairs of state-of-charge difference values and charge throughput values if the respective charge throughput values are outliers.

5. The computer-implemented method of any one of the preceding claims,
wherein the respective pairs of state-of-charge difference values and charge throughput values are obtained at a server from a battery management system of the rechargeable battery.

6. The computer-implemented method of any one of the preceding claims,
wherein said obtaining of the respective pairs of state-of-charge difference values and charge throughput values for the sequence of charging or discharging half-cycles of the rechargeable battery comprises determining the charge throughput values by calculating a trapezoidal sum of current flows throughout the charging or discharging half-cycles.

7. The computer-implemented method of any one of the preceding claims,
wherein cost function is formulated so that the state-of-charge difference values correspond to an input signal of the recursive filter and that the charge throughput values correspond to an output signal of the recursive filter.

8. The computer-implemented method of any one of the preceding claims,
wherein said obtaining of the respective pairs of state-of-charge difference values and charge throughput values for the sequence of charging or discharging half-cycles of the rechargeable battery comprises determining the state-of-charge difference values using a machine-learning model, the machine-learning model receiving, as input, a time-sequence of terminal voltages of the rechargeable battery during the respective charging or discharging half-cycle.

9. The computer-implemented method of claim 8,
wherein the machine-learned model has been trained for a different type of rechargeable batteries than a type of the rechargeable battery for which the estimate of the capacity is determined.

10. A processing device configured to execute the method of any one of the preceding claims.

11. A computer program comprising program code executable by at least one processor, wherein the at least one processor, upon executing the program code, performs the method of any one of claims 1 to 9.

**Patentansprüche**

1. Computerimplementiertes Verfahren zum Schätzen einer Kapazität einer wiederaufladbaren Batterie, wobei das Verfahren Folgendes umfasst:

- Erhalten (3010, 3015), für eine Sequenz von Lade- oder Entladehalbzyklen der wiederaufladbaren Batterie, jeweiliger Paare von Ladezustandsdifferenzwerten und Ladungsdurchsatzwerten, und
- für jeden Lade- oder Entladehalbzyklus der Sequenz von Lade- oder Entladehalbzyklen, Ermitteln (3025) einer aktuellen Schätzung der Kapazität durch Aktualisieren einer vorherigen Schätzung der Kapazität der wiederaufladbaren Batterie auf der Grundlage eines rekursiven Filters,

wobei das rekursive Filter auf einer Kostenfunktion basiert, die von einer Differenz zwischen dem jeweiligen Ladezustandsdifferenzwert und einem ReferenzLadezustandsdifferenzwert abhängt, wobei der Referenzladezustandsdifferenzwert von dem jeweiligen Ladungsdurchsatz und der aktuellen Abschätzung der Kapazität abhängig ist.

2. Computerimplementiertes Verfahren nach Anspruch 1, wobei die Kostenfunktion Differenzen zwischen den Ladezustandsdifferenzwerten und Referenzladezustandsdifferenzwerten für neuere Lade- oder Entladehalbzyklen überbetont.

3. Computerimplementiertes Verfahren nach Anspruch 1 oder 2, ferner umfassend:

   - Verwerfen (3020) eines oder mehrerer Paare von Ladezustandsdifferenzwerten und Ladungsdurchsatzwerten, wenn die jeweiligen Ladezustandsdifferenzwerte unter einem vorbestimmten Schwellenwert liegen.

4. Computerimplementiertes Verfahren nach einem der vorhergehenden Ansprüche, ferner umfassend:

   - Verwerfen (3020) eines oder mehrerer Paare von Ladezustandsdifferenzwerten und Ladungsdurchsatzwerten, wenn die jeweiligen Ladungsdurchsatzwerte Ausreißer sind.

5. Computerimplementiertes Verfahren nach einem der vorhergehenden Ansprüche,
   wobei die jeweiligen Paare von Ladezustandsdifferenzwerten und Ladungsdurchsatzwerten an einem Server von einem Batteriemanagementsystem der wiederaufladbaren Batterie erhalten werden.

6. Computerimplementiertes Verfahren nach einem der vorhergehenden Ansprüche,
   wobei das Erhalten der jeweiligen Paare von Ladezustandsdifferenzwerten und Ladungsdurchsatzwerten für die Sequenz von Lade- oder Entladehalbzyklen der wiederaufladbaren Batterie das Ermitteln der Ladungsdurchsatzwerte durch Berechnen einer trapezförmigen Summe von Stromflüssen während der Lade- oder Entladehalbzyklen umfasst.

7. Computerimplementiertes Verfahren nach einem der vorhergehenden Ansprüche,
   wobei die Kostenfunktion so formuliert ist, dass die Ladezustandsdifferenzwerte einem Eingangssignal des rekursiven Filters entsprechen und dass die Ladungsdurchsatzwerte einem Ausgangssignal des rekursiven Filters entsprechen.

8. Computerimplementiertes Verfahren nach einem der vorhergehenden Ansprüche,
   wobei das Erhalten der jeweiligen Paare von Ladezustandsdifferenzwerten und Ladungsdurchsatzwerten für die Sequenz von Lade- oder Entladehalbzyklen der wiederaufladbaren Batterie das Ermitteln der Ladezustandsdifferenzwerte unter Verwendung eines Maschinenlernmodells umfasst, wobei das Maschinenlernmodell als Eingabe eine Zeitsequenz von Klemmenspannungen der wiederaufladbaren Batterie während des jeweiligen Lade- oder Entladehalbzyklus empfängt.

9. Computerimplementiertes Verfahren nach Anspruch 8,
   wobei das maschinell erlernte Modell für einen anderen Typ von wiederaufladbaren Batterien als einen Typ der wiederaufladbaren Batterie trainiert wurde, für den die Schätzung der Kapazität ermittelt wird.

10. Verarbeitungsvorrichtung, die dazu konfiguriert ist, das Verfahren nach einem der vorhergehenden Ansprüche auszuführen.

11. Computerprogramm, das einen Programmcode umfasst, der durch mindestens einen Prozessor ausführbar ist, wobei der mindestens einen Prozessor beim Ausführen des Programmcodes das Verfahren nach einem der Ansprüche 1 bis 9 durchführt.

**Revendications**

1. Procédé mis en œuvre par ordinateur pour estimer une capacité d'une batterie rechargeable, le procédé comprenant :

   - obtenir (3010, 3015), pour une séquence de demi-cycles de charge ou de décharge de la batterie rechargeable, des paires respectives de valeurs de différence d'état de charge et de valeurs de débit de charge, et
   - pour chaque demi-cycle de charge ou de décharge de la séquence de demi-cycles de charge ou de décharge, déterminer (3025) une estimation actuelle de la capacité en mettant à jour une estimation précédente de la capacité de la batterie rechargeable sur la base d'un filtre récursif,
   dans lequel le filtre récursif est basé sur une fonction de coût qui dépend d'une différence entre la valeur de différence d'état de charge respective et une
   valeur de différence d'état de charge de référence, la valeur de différence d'état de charge de référence dépendant du débit de charge respectif et de l'estimation actuelle de la capacité.

**2.** Procédé mis en œuvre par ordinateur de la revendication 1,
la fonction de coût met l'accent sur les différences entre les valeurs de différence d'état de charge et les valeurs de différence d'état de charge de référence pour les demi-cycles de charge ou de décharge les plus récents.

**3.** Procédé mis en œuvre par ordinateur selon la revendication 1 ou 2, comprenant en outre :

- rejeter (3020) une ou plusieurs paires de valeurs de différence d'état de charge et de valeurs de débit de charge si les valeurs respectives de différence d'état de charge sont inférieures à un seuil prédéterminé.

**4.** Procédé mis en œuvre par ordinateur selon l'une quelconque des revendications précédentes, comprenant en outre :

- rejeter (3020) une ou plusieurs paires de valeurs de différence d'état de charge et de valeurs de débit de charge si les valeurs de débit de charge respectives sont aberrantes.

**5.** Procédé mis en œuvre par ordinateur selon l'une quelconque des revendications précédentes,
dans lequel les paires respectives de valeurs de différence d'état de charge et de valeurs de débit de charge sont obtenues au niveau d'un serveur à partir d'un système de gestion de batterie de la batterie rechargeable.

**6.** Procédé mis en œuvre par ordinateur selon l'une quelconque des revendications précédentes,
dans lequel ladite obtention des paires respectives de valeurs de différence d'état de charge et de valeurs de débit de charge pour la séquence de demi-cycles de charge ou de décharge de la batterie rechargeable comprend la détermination des valeurs de débit de charge en calculant une somme trapézoïdale de flux de courant tout au long des demi-cycles de charge ou de décharge.

**7.** Procédé mis en œuvre par ordinateur selon l'une quelconque des revendications précédentes,
dans lequel la fonction de coût est formulée de sorte que les valeurs de différence d'état de charge correspondent à un signal d'entrée du filtre récursif et que les valeurs de débit de charge correspondent à un signal de sortie du filtre récursif.

**8.** Procédé mis en œuvre par ordinateur selon l'une quelconque des revendications précédentes,
dans lequel ladite obtention des paires respectives de valeurs de différence d'état de charge et de valeurs de débit de charge pour la séquence de demi-cycles de charge ou de décharge de la batterie rechargeable comprend la détermination des valeurs de différence d'état de charge à l'aide d'un modèle d'apprentissage automatique, le modèle d'apprentissage automatique recevant, en entrée, une séquence temporelle de tensions aux bornes de la batterie rechargeable pendant le demi-cycle de charge ou de décharge respectif.

**9.** Procédé mis en œuvre par ordinateur de la revendication 8,
dans lequel le modèle appris par machine a été formé pour un type de batteries rechargeables différent d'un type de batterie rechargeable pour lequel l'estimation de la capacité est déterminée.

**10.** Dispositif de traitement configuré pour exécuter le procédé selon l'une quelconque des revendications précédentes.

**11.** Programme informatique comprenant un code de programme exécutable par au moins un processeur, dans lequel le au moins un processeur, lors de l'exécution du code de programme, exécute le procédé selon l'une quelconque des revendications 1 à 9.

## FIG. 1

# FIG. 2

# FIG. 3
# (prior art)

# FIG. 4

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Non-patent literature cited in the description**

- **PLETT, GREGORY L.** Recursive approximate weighted total least squares estimation of battery cell total capacity.. *Journal of Power Sources*, 2011, vol. 196 (4), 2319-2331

- **KARAVALAKIS, NIKOLAOS.** *Online capacity estimation of Li-ion batteries with Errors-In-Variables model.*, 2019